# EUROPÄISCHE PATENTSCHRIFT

(11) **EP 2 848 879 B1**
(45) Veröffentlichungstag und Bekanntmachung des Hinweises auf die Patenterteilung: **06.04.2016**
(21) Anmeldenummer: 14003633.6
(22) Anmeldetag: 02.01.2012
(51) Int. Cl.: F25D 19/00, F25B 9/14, H02K 55/04, H02K 9/20, H01L 23/427

(54) **Kühleinrichtung für einen Supraleiter und supraleitende Synchronmaschine**
Cooling device for a super conductor and superconducting synchronous engine
Dispositif frigorifique pour un supraconducteur et machine synchrone supraconductrice

(30) Priorität: 13.01.2011 DE 102011002622
(43) Veröffentlichungstag der Anmeldung: 18.03.2015
(62) Teilanmeldung aus: 12700375.4
(73) Patentinhaber: Siemens Aktiengesellschaft, 80333 München (DE)
(72) Erfinder: Frank, Michael, 91080 Uttenreuth (DE); Kummeth, Peter, 91074 Herzogenaurach (DE); Nick, Wolfgang, 90419 Nürnberg (DE); Schmidt, Heinz, 91096 Möhrendorf (DE)

(56) Entgegenhaltungen:
- DE-A1- 10 321 463
- US-A- 4 079 273
- US-B1- 6 438 969

## Beschreibung

Die Erfindung betrifft eine Kühleinrichtung für einen Supraleiter, insbesondere einen Hochtemperatur-Supraleiter einer Synchronmaschine, umfassend einen Kühlkreislauf für ein Kühlmedium, wobei das in einem Kaltkopf mit einem Kondensor verflüssigte Kühlmedium zu dem zu kühlenden Supraleiter, insbesondere in den Rotor der Synchronmaschine, geleitet und gasförmig zurück zu dem Kondensor geführt wird. Daneben betrifft die Erfindung eine supraleitende Synchronmaschine, insbesondere zum Einsatz auf einem Seefahrzeug.

Eine Kühleinrichtung für einen Supraleiter gemäß dem Oberbegriff von Anspruch 1 ist in DE 10321463 A1 offenbart.

In sogenannten supraleitenden Maschinen ist wenigstens eine supraleitende Wicklung vorgesehen, wobei häufig die sogenannten Hochtemperatur-Supraleiter (HTS-Supraleiter) verwendet werden. HTS-Supraleiter nennt man metalloxidische Supraleitermaterialien mit Sprungtemperaturen T_{c} von über 77K.

Für die Kühlung von Supraleitern, insbesondere auch in supraleitenden Maschinen, werden üblicherweise kryogene Flüssigkeiten als Kühlmedium eingesetzt. So sind beispielsweise für HTS-Supraleiter Kühleinrichtungen bekannt, bei denen in einem geschlossenen System beispielsweise Neongas oder Stickstoff als Kühlmedium an einem Kaltkopf mit Kondensor verflüssigt wird. Von dort aus fließt das Kühlmedium in das dem Supraleiter tragende Bauteil, beispielsweise einem zu kühlenden Rotor. Das verdampfende Kühlmedium gelangt zurück zum Kondensor und wird dort erneut verflüssigt. Dabei wird der sogenannte Thermosiphon-Effekt ausgenutzt. Das flüssige Kühlmedium verdampft an einem den Supraleiter tragenden, wärmeleitenden Träger, insbesondere einem Wicklungsträger, und strömt gasförmig aufgrund des Druckunterschieds, der aufgrund des Verdampfens im Verdampfer und des Kondensierens im Kondensorraum des Kondensors entsteht, zum Kondensor zurück. Solche Kältemittelströmungen werden auch als "Heat-Pipe" bezeichnet.

Der Transport des flüssigen Kühlmediums zu dem Supraleiter wird bei den bekannten Kühleinrichtungen durch die Schwerkraft bewerkstelligt. Das bedeutet, der Kondensor ist geodätisch höher als der Verdampfer angeordnet. Insgesamt wird ein geschlossenes Kühlsystem gebildet.

Diese Vorgehensweise erweist sich immer dann als schwierig, wenn eine Schräglage der Kühleinrichtung beziehungsweise der sie umfassenden Synchronmaschine auftreten kann, wie es beispielsweise bei supraleitenden Synchronmaschinen für Schiffsanwendungen, also beispielsweise HTS-Motoren oder HTS-Generatoren, möglich ist. Bei Seefahrzeugen wie Schiffen kann es leicht zu einer Schräglage beziehungsweise Neigung des Schiffes kommen. Derartige statische Schieflagen werden "Trim" genannt, aber auch dynamische Schieflagen sind möglich. Dann kann das flüssige Kühlmedium gegebenenfalls nicht in den Verdampfer gelangen und seine Kühlwirkung entfalten.

Zur Lösung dieser Problematik wurde vorgeschlagen, dass immer dann, wenn eine Neigung der Kühleinrichtung und insbesondere somit auch der Kühlmediumleitung auftreten kann, die geodätische Höhe des Flüssigkeitsspiegels genutzt wird, oder gar, dass die gesamte supraleitenden Maschine bereits geneigt installiert wird. Dies bedeutet insbesondere, dass der Kondensor mit dem Kaltkopf deutlich höher als der zu kühlende Supraleiter angeordnet wird. Bei genügend flüssigem Kühlmedium im geschlossenem System und damit genügend hochstehendem Flüssigkeitsspiegel kann somit trotz einer ansteigenden Kühlmediumleitung das flüssige Kühlmedium zu dem Supraleiter, insbesondere in den Rotor, geführt werden.

Diese Vorgehensweise hat zum einen den Nachteil, dass eine große Menge an flüssigem Kühlmedium in dem System vorgehalten werden muss. Zum anderen sind bezüglich der Anordnung der verschiedenen Komponenten und des Verlaufs der Leitungen für das Kühlmedium Beschränkungen gegeben, was das Design der Kühleinrichtung angeht.

Diese Designbeschränkungen sind auch in anderen Anwendungsfeldern gegeben, wenn eine Raumknappheit vorliegt, die es nicht erlaubt, einen geodätisch höher liegenden Kondensor mit einem Kaltkopf, der üblicherweise mit einer Kältemaschine verbunden ist, vorzusehen. Dies gilt beispielsweise bei Höhenbeschränkungen für eine Vorrichtung, beispielsweise einen Triebwagen einer Eisenbahn oder dergleichen.

Eine Verwendung mechanischer Mittel wie Pumpen erfordert einen hohen apparativen und energetischen Aufwand, der gerade für niedrige Kühlmediumtemperaturen noch steigt.

Der Erfindung liegt daher die Aufgabe zugrunde, eine Kühleinrichtung für einen Supraleiter anzugeben, die auf verlässliche Weise das Kühlmedium zu dem zu kühlenden Supraleiter transportiert, ohne dabei auf einer Gravitationswirkung zu basieren und den entsprechenden Einschränkungen unterworfen zu sein.

Zur Lösung dieser Aufgabe ist bei einer Kühleinrichtung der eingangs genannten Art erfindungsgemäß vorgesehen, dass zur Förderung des Kühlmediums aus dem Kondensor zu dem Supraleiter ein durch einen mittels einer Wärmequelle verdampften Anteil des verflüssigen Kühlmediums erzeugter Druck dient.

Erfindungsgemäß wird eine Kühleinrichtung für einen Supraleiter gemäß Anspruch 1 vorgeschlagen.

Die Kühleinrichtung ist mit einer Wärmequelle versehen, die im Förderungsabschnitt zwischen dem Kondensor und dem zu kühlenden Supraleiter angeordnet und zu einem Betrieb derart ausgebildet ist, dass durch das verdampfte, mithin voluminösere Kühlmedium ein Druck aufgebaut wird, der das Kühlmedium zu dem zu kühlenden Supraleiter fördert. Auf diese Weise ist es möglich, das flüssige Kühlmedium ohne Ausnutzung der Schwerkraft bergauf zu dem zu kühlenden Supraleiter, insbesondere in den Rotor, zu fördern. Ausgenutzt wird dabei ein Druckanstieg, der durch eine Wärmequelle im Bereich des flüssigen Kühlmediums verursacht wird und das Kühlmedium letztlich zu dem Supraleiter hin presst. Insbesondere ist eine derartige Kühlmediumversorgung schiffstauglich, nachdem das flüssige Kühlmedium unabhängig von der tatsächlichen Lage des Schiffes bezüglich der Horizontalen gefördert werden kann. Die Menge an flüssigem Kühlmedium kann flexibler gewählt werden und der Kondensor muss sich nicht mehr zwingend höher als die Austrittsöffnung des Leitungsabschnitts in dem den Supraleiter tragenden Bauteil, insbesondere dem Rotor, befinden. Im Falle einer Synchronmaschine kann der Supraleiter beispielsweise auf einem thermisch leitfähigen Wicklungsträger befestigt werden, der die Begrenzung eines Innenraums des Rotors, der als Verdampferraum wirkt, bildet.

Konkret kann dabei vorgesehen sein, dass ein durch einen ersten Leitungsabschnitt mit dem Kondensor und durch einen zweiten Leitungsabschnitt mit dem den zu kühlenden Supraleiter tragenden, als Verdampfer wirkenden Bauteil, insbesondere dem Rotor, verbundenes Reservoir für flüssiges Kühlmedium vorgesehen ist, an das die Wärmequelle angekoppelt ist. In dem Reservoir wird folglich ein Teil des flüssigen Kühlmediums in einen gasförmigen Zustand übergeführt, so dass ein Druck entsteht, der das Kühlmedium aus dem Reservoir zu dem Supraleiter hin fördert.

Dabei ermöglicht es die vorliegende Erfindung insbesondere, dass der zweite Leitungsabschnitt als ein Steigrohr ausgebildet ist. Durch den mittels des von der Wärmequelle verdampften Anteils des Kühlmediums erzeugten Druck kann das Kühlmedium mithin letztlich gegen die Schwerkraft, also bergauf, gefördert werden.

Nachdem bei der vorliegenden Erfindung nicht mehr die Schwerkraft die fördernde Kraft liefert, wird es zudem ermöglicht, dass der zweite Leitungsabschnitt wenigstens teilweise flexibel ist. Es muss also kein starres Rohr mehr verwendet werden, sondern es ist beispielsweise möglich, dass der zweite Leitungsabschnitt einen Wellenschlauch und/oder ein Balg umfasst, durch den das flüssige Kühlmedium strömt, getrieben durch den Druck im Reservoir.

In besonders zweckmäßiger Ausgestaltung der vorliegenden Erfindung kann vorgesehen sein, dass dem Reservoir kondensorseitig vorgeschaltet ein Ventil, insbesondere ein Rückschlagventil, vorgesehen ist. Das Ventil dient folglich dem Zweck, den vom Reservoir aus ja in beide Leitungsabschnitte drängenden Druck bei geschlossenem Ventil auf den zweiten Leitungsabschnitt in Richtung des zu kühlenden Bauteils beziehungsweise Supraleiters zu richten, um eine effektive Förderung zu erreichen. Während es grundsätzlich möglich ist, worauf im Folgenden noch näher eingegangen wird, ein gesteuertes Ventil zu verwenden, wird es erfindungsgemäß bevorzugt, ein Rückschlagventil einzusetzen, das ohne eine weitere Steuerung es lediglich erlaubt, dass das Kühlmedium in das Reservoir aus dem Kondensor nachströmt, nicht jedoch, dass flüssiges Kühlmittel zurück in den Kondensor gepresst wird. Es ist vorteilhafter Weise keine Ventilsteuerung bei einem Rückschlagventil notwendig, so dass die Betriebssicherheit zunimmt, nachdem ein Durchbrennen des Ventils ausgeschlossen ist.

Vorzugsweise kann bei Verwendung eines Gravitationskräfte nutzenden Rückschlagventils das Gravitationskräfte nutzende Rückschlagventil in dem aufsteigenden, dem Reservoir benachbarten Teil eines Siphons angeordnet sein. Dabei können beispielsweise Rückschlagventile verwendet werden, die auf einer der Gravitation ausgesetzten Last, beispielsweise einer in dem Rückschlagventil vorgesehenen Kugel, basieren. Der Leitungsabschnitt zum Flüssigkeitsreservoir wird folglich als ein Siphon ausgebildet und das Rückschlagventil wird im ansteigenden Leitungsteil kurz vor dem Reservoir platziert.

Wie bereits erwähnt, erlaubt es die vorliegende Erfindung allgemein, dass der Kondensor niedriger angeordnet ist als der kühlende Supraleiter, so dass eine derartige Ausgestal tung bei der erfindungsgemäßen Kühleinrichtung auch gezielt gewählt werden kann.

Erfindungsgemäß wird als Wärmequelle eine über eine Wärmebrücke angekoppelte Verbindung zu einem Gas, insbesondere der Außenluft, verwendet, wobei die Temperatur des Gases höher als die Siedetemperatur des Kühlmediums ist. Es kann also auch eine Ankopplung des flüssigen Kühlmediums, insbesondere des Reservoirs, an ein über dem Siedepunkt des Kühlmediums liegendes Temperaturniveau verwendet werden, insbesondere in Verbindung mit der Verwendung eines oben genannten gesteuerten Ventils. Dabei handelt es sich also um eine passive Wärmeankopplung an das Reservoir, so dass durch Verzicht auf ein aktiv betriebenes Heizmittel die Ausfallsicherheit der Kühleinrichtung weiter erhöht werden kann. Allerdings muss hier bei der Ausgestaltung darauf geachtet werden, dass, insbesondere bei geöffnetem ansteuerbaren Ventil, ein Nachstrom an flüssigem Kühlmedium in das Reservoir beziehungsweise den Ort, an dem die Wärmequelle angreift, gesichert ist. Dabei kann insbesondere auch eine Art thermische Verbindung "nach außen" genutzt werden, so dass die Umgebungsluft als Wärmeträger genutzt werden kann. Möglich ist es natürlich auch, andere Gase oder Kühlmittel zu verwenden.

Neben der Kühleinrichtung betrifft die vorliegende Erfindung auch eine supraleitende Synchronmaschine, insbesondere eine HTS-Synchronmaschine, insbesondere zum Einsatz auf einem Seefahrzeug, umfassend eine erfindungsgemäße Kühleinrichtung. Wie bereits eingangs dargelegt, wird bei der Förderung des Kühlmediums zu dem zu kühlenden Supraleiter auf Gravitation verzichtet, so dass die Auswirkungen einer Schräglage bei der erfindungsgemäßen Kühleinrichtung weitaus geringer sind. Eine Synchronmaschine, die mit einer erfindungsgemäßen Kühleinrichtung ausgestattet ist, kann also besonders vorteilhaft auf einem Schiff eingesetzt werden, beispielsweise als Generator oder Motor. Auch bei anderen Anwendungen, bei denen aufgrund möglicher Schräglagen zur Schwerkraft eine Förderung durch die Gravitation unsicher erscheint, kann die erfindungsgemäße Kühleinrichtung genauso eingesetzt werden wie in Anwendungen, in denen bauliche Beschränkungen ein höher als der den Verdampfungsraum stellende Rotor angeordneter Kondensor nicht realisiert werden kann.

Sämtliche Ausführungen bezüglich der erfindungsgemäßen Kühleinrichtung lassen sich analog auf die erfindungsgemäße Synchronmaschine übertragen, so dass auch hiermit die genannten Vorteile erreicht werden können.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine Prinzipskizze einer Kühleinrichtung,
- Fig. 2: einen Graphen zum Betrieb eines Heizmittels, und
- Fig. 3: eine Prinzipskizze eines Ausführungsbeispiels der erfindungsgemäßen Kühleinrichtung.

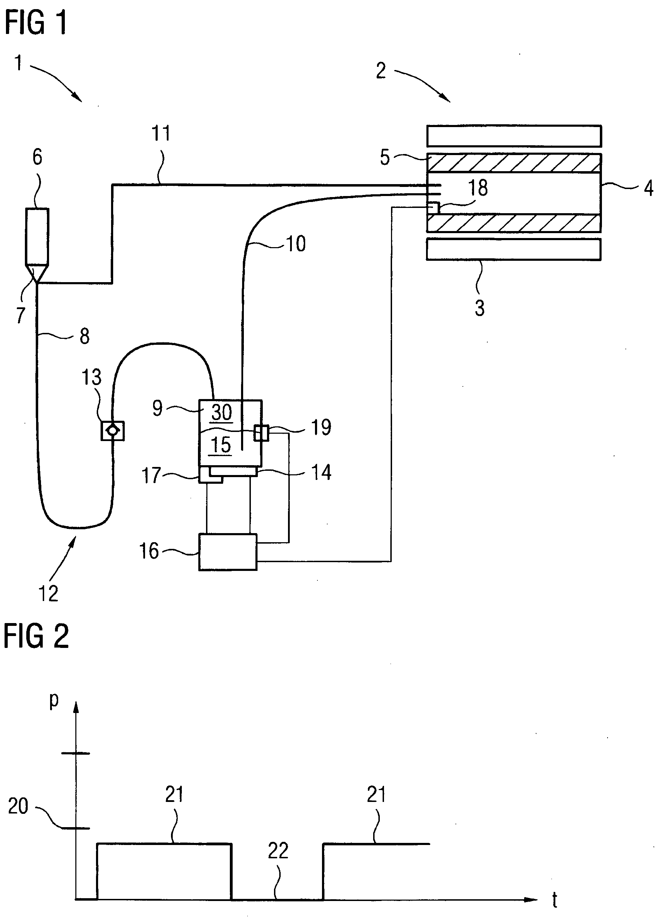

Fig. 1 zeigt eine Prinzipskizze einer Kühleinrichtung 1, die einer in einem Schiff betriebenen Synchronmaschine 2 zugeordnet ist, um innerhalb eines relativ zu einem Stator 3 drehbaren Rotors 4 angeordnete supraleitende Wicklungen 5 zu kühlen. Die Wicklungen 5 sind aus einem Hochtemperatur-Supraleiter gefertigt und werden von einem thermisch leitfähigen Wicklungsträger getragen, der in einem Vakuumgehäuse angeordnet ist und dessen innere Begrenzungen einen im Wesentlichen zylindrischen, sich in Achsrichtung erstreckenden Innenraum bilden.

Im vorliegenden Fall wird als Kühlmedium zur Kühlung des Supraleiters Neongas verwendet, das in einem geschlossenen Kühlkreislauf bewegt wird. In einem Kondensorraum eines Kondensors 7, der thermisch mit einem Kaltkopf 6, der thermisch wie grundsätzlich bekannt an eine Kältemaschine gekoppelt ist, verbunden ist, wird gasförmiges Kühlmedium verflüssigt. Dieses flüssige Kühlmedium wird nun über einen ersten Leitungsabschnitt 8, ein Reservoir 9 und einen zweiten Leitungsabschnitt 10 zu den supraleitenden Wicklungen 5 im Rotor 4 geführt, wobei die Einleitung des flüssigen Kühlmediums in den Rotor 4 im Stand der Technik hinreichend bekannt ist und hier nicht näher dargelegt werden muss.

Im Rahmen der Kühlwirkung verdampft das Kühlmedium an dem Wicklungsträger und kühlt so die Wicklungen 5. Der Innenraum des Rotors 4 wirkt also als Verdampfungsraum. Das Kühlmedium wird über eine Rückführleitung 11 wieder zum Kondensor 7 geführt, wo es erneut verflüssigt wird. Damit schließt sich der Kühlkreislauf.

Nachdem der Kondensor 7 deutlich niedriger angeordnet ist, als der Rotor 4, und der zweite Leitungsabschnitt 10 als ein Steigrohr ausgebildet ist, wird bei der Kühleinrichtung 1 nicht die Gravitation als Förderkraft verwendet. Zur Förderung des flüssigen Kühlmediums durch den zweiten Leitungsabschnitt 10 in den Rotor 4 wird vielmehr ein durch verdampftes Kühlmedium 30 erzeugter Druck verwendet.

Ersichtlich bildet der erste Leitungsabschnitt 8 vor dem Reservoir 9 einen Siphon 12, in dessen dem Reservoir 9 benachbarten, entgegen der Schwerkraft bergauf gerichteten Teilabschnitt ein Rückschlagventil 13 vorgesehen ist. Am Boden des Reservoirs 9 ist ein Heizmittel 14 als Wärmequelle angeordnet, hier ein elektrisches Heizmittel 14. Bei Betrieb wirkt das Heizmittel 14 auf das im Reservoir 9 befindliche flüssige Kühlmedium 15, so dass das verdampfte Kühlmedium 30 entsteht und ein Druck auftritt. Dieser Druck fördert das flüssige Kühlmedium 15 durch den zweiten Leitungsabschnitt 10 in den Innenraum des Rotors 4, jedoch nicht zurück zum Kondensor 7, nachdem das Rückschlagventil 13 automatisch schließt.

Das Heizmittel 14 wird zyklisch betrieben, gesteuert von einer Steuereinrichtung 16. Die Steuereinrichtung 16 regelt den Betrieb des Heizmittels 14 dabei aufgrund der Daten eines Temperatursensors 17, der die Temperatur des Heizmittels 14 misst, eines Temperatursensors 18, der die Temperatur in dem Rotor 4 misst, und eines Füllstandsensors 19, der den Füllstand des Reservoirs 9 misst. Durch diese Regelung ergibt sich insgesamt ein zyklischer Betrieb des elektrischen Heizmittels 14, wobei die Betriebsphasen deutlich länger als bei Impulskühlungen gewählt werden können und analog niedrige Heizleistungen während den Betriebsphasen gefahren werden können. Beispielsweise kann das Verhältnis der Zeit, in der das Heizmittel aktiv ist, also der Betriebsphase, zu der Nichtbetriebsphase größer als 40 %, bevorzugt größer als 50 %, gewählt werden. Die Heizleistung kann dabei so gewählt werden, dass sie kleiner als das Doppelte der Kaltkopfleistung, insbesondere kleiner als die Kaltkopfleistung, ist. Es sei an dieser Stelle noch angemerkt, dass in Fällen, in denen eine lange Betriebsphase des Heizmittels 14 vorgesehen werden soll, es sinnvoll sein kann, einen Sammelbehälter für flüssiges Kühlmedium 15 am Kaltkopf vorzusehen, um das Kühlmedium 15 in Phasen, in denen kein Kühlmedium nachströmen kann, zurückzuhalten.

Wird also durch den Betrieb des Heizmittels 14 der Druck aufgebaut, schließt sich das Rückschlagventil 13 und flüssiges Kühlmedium 15 wird in den Rotor 4 gefördert. Während einer Nichtbetriebsphase des Heizmittels 14 kann sich das Rückschlagventil 13 wieder öffnen und es strömt flüssiges Kühlmedium 15 in das Reservoir 9 nach. Die niedrigen Heizleistungen und langen Betriebsdauern verlängern die Lebensdauer des Heizmittels 14 und sorgen für eine quasikontinuierliche Förderung von Kühlmedium 15 in den Rotor 4. Die Dauer der Betriebsphasen kann dabei, je nach Auslegung des Systems, im Sekunden- oder Minutenbereich liegen.

Es sei an dieser Stelle angemerkt, dass statt des Rückschlagventils 13 auch ein gesteuertes Ventil verwendet werden kann, welches auch von der Steuereinrichtung 16 angesteuert wird.

In diesem Ausführungsbeispiel ist der zweite Leitungsabschnitt 10 teilweise flexibel, beispielsweise in Form eines Wellenschlauchs und/oder Balgs ausgebildet, was möglich ist, da die Förderung ja nicht über die Gravitationskraft erfolgt, sondern mittels des aufgebauten Drucks im Reservoir 9.

Fig. 2 zeigt nun nochmals verdeutlichend mögliche Betriebsphasen des Heizmittels 14, wobei die Heizleistung gegen die Zeit aufgetragen ist. Der Wert 20 entspricht dabei der Kaltkopfleistung. Ersichtlich können lange Betriebsphasen 21 bei einer niedrigen Leistung realisiert werden, die durch Nichtbetriebsphasen 22 getrennt sind.

Es sei weiterhin angemerkt, dass es grundsätzlich auch möglich ist, dass die Steuereinrichtung 16 zur Regelung des absoluten Betrages der Heizleistung während der Betriebsphasen des Heizmittels 14 ausgebildet sein kann, wenn eine derartige Regelung zweckmäßig ist.

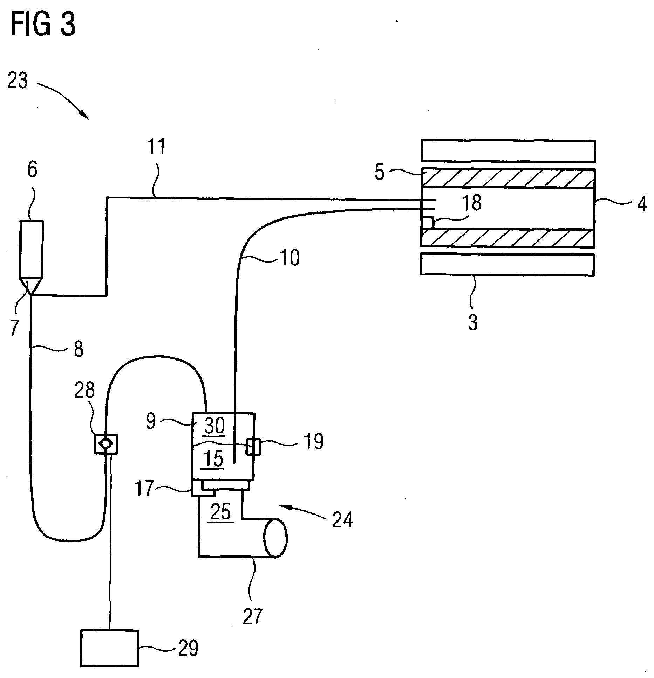

Fig. 3 zeigt eine Ausführungsform einer erfindungsgemäßen Kühleinrichtung 23, wobei der Einfachheit halber gleiche Komponenten mit dem gleichen Bezugszeichen versehen sind. Bezüglich des Rotors 4, der Leitungsabschnitte und Leitungen 8, 10 und 11, des Kondensors 7 und des Kaltkopfes 6 sowie des Reservoirs 9 sind keine Unterschiede gegeben. Allerdings wird hier im Unterschied zur Kühleinrichtung 1 als Wärmequelle 24 ein über eine Wärmebrücke 25 angekoppeltes Gas 26, hier über ein Rohr 27 die Außenluft, verwendet. Es liegt demnach ein kontinuierlicher Wärmeeintrag vor, so dass zudem statt dem Rückschlagventil 13 ein gesteuertes Ventil 28 vorgesehen ist, welches über eine Steuereinrichtung 29 betrieben wird, gegebenenfalls wiederum in Abhängigkeit der Messwerte der Sensoren 17, 18 und 19. Immer dann, wenn flüssiges Kühlmedium 15 in das Reservoir nachströmen soll, wird das Ventil 28 geöffnet.

## Patentansprüche

1. Kühleinrichtung (1, 23) für einen Supraleiter, insbesondere einen Hochtemperatur-Supraleiter einer Synchronmaschine (2), umfassend einen Kühlkreislauf für ein Kühlmedium (30, 15), wobei das in einem Kaltkopf (6) mit einem Kondensor (7) verflüssigte Kühlmedium (15) zu dem zu kühlenden Supraleiter, insbesondere in den Rotor (4) der Synchronmaschine (2), geleitet und gasförmig zurück zu dem Kondensor (7) geführt wird, wobei zur Förderung des Kühlmediums (30, 15) aus dem Kondensor (7) zu dem Supraleiter ein durch einen mittels einer Wärmequelle (24) verdampften Anteil (30) des Kühlmediums (30, 15) erzeugter Druck dient,
**dadurch gekennzeichnet,**
- **dass** als Wärmequelle (24) eine über eine Wärmebrücke (25) angekoppelte Verbindung zu einem Gas (26), insbesondere der Außenluft, verwendet wird, wobei die Temperatur des Gases (26) höher als die Siedetemperatur des Kühlmediums (30, 15) ist.

2. Kühleinrichtung nach Anspruch 1, **dadurch gekennzeichnet, dass** ein durch einen ersten Leitungsabschnitt (8) mit dem Kondensor (7) und durch einen zweiten Leitungsabschnitt (10) mit dem den zu kühlenden Supraleiter tragenden Bauteil, insbesondere dem Rotor (4), verbundenes Reservoir (9) für flüssiges Kühlmedium (15) vorgesehen ist, an das die Wärmequelle (24) angekoppelt ist.

3. Kühleinrichtung nach Anspruch 2, **dadurch gekennzeichnet, dass** der zweite Leitungsabschnitt (10) als ein Steigrohr ausgebildet ist.

4. Kühleinrichtung nach Anspruch 2 oder 3, **dadurch gekennzeichnet, dass** der zweite Leitungsabschnitt (10) wenigstens teilweise flexibel ist.

5. Kühleinrichtung nach einem der Ansprüche 2 bis 4, **dadurch gekennzeichnet, dass** dem Reservoir (9) kondensorseitig vorgeschaltet ein Ventil (13, 28), insbesondere ein Rückschlagventil (13), vorgesehen ist.

6. Kühleinrichtung nach Anspruch 5, **dadurch gekennzeichnet, dass** das Gravitationskräfte nutzende Rückschlagventil (13) in dem aufsteigenden, dem Reservoir (9) benachbarten Teil eines Siphons (12) angeordnet ist.

7. Kühleinrichtung nach einem der vorangehenden Ansprüche, dass der Kondensor (7) niedriger angeordnet ist als der zu kühlende Supraleiter.

8. Supraleitende Synchronmaschine (2), insbesondere zum Einsatz auf einem Seefahrzeug, umfassend eine Kühleinrichtung (1, 23) nach einem der vorangehenden Ansprüche.

## Claims

1. Cooling device (1, 23) for a superconductor, in particular a high temperature superconductor of a synchronous machine (2), comprising a cooling circuit for a coolant (30, 15), the coolant (15) liquefied in a cold head (6) with a condenser (7) being conducted to the superconductor to be cooled, in particular into the rotor (4) of the synchronous machine (2) and being returned to the condenser (7) in a gaseous form, wherein a pressure generated by a component (30) of the coolant (30, 15) evaporated by means of a heat source (14) is used to convey the coolant (30, 15) from the condenser (7) to the superconductor,
**characterised in that**
- a connection to a gas (26), in particular outside air, coupled by way of a thermal bridge (25), is used as the heat source (24), the temperature of the gas (26) being higher than the boiling temperature of the coolant (30, 15).

2. Cooling device according to claim 1, **characterised in that** a reservoir (9) connected by a first line segment (8) to the condenser (7) and by a second line segment (10) to the part supporting the superconductor to be cooled, in particular the rotor (4), is provided for liquid coolant (15), with the heat source (14) coupled thereto.

3. Cooling device according to claim 2, **characterised in that** the second line segment (10) is configured as a rising pipe.

4. Cooling device according to claim 2 or 3, **characterised in that** the second line segment (10) is at least partially flexible.

5. Cooling device according to one of claims 2 to 4, **characterised in that** a valve (13, 28), in particular a non-return valve (13), is provided upstream of the reservoir (9) on the condenser side.

6. Cooling device according to claim 5, **characterised in that** the non-return valve (13) that utilises gravitation forces is disposed in the rising part of a siphon (12) adjacent to the reservoir (9).

7. Cooling device according to one of the preceding claims, **characterised in that** the condenser (7) is disposed lower than the superconductor to be cooled.

8. Superconducting synchronous machine (2), in particular for use on a vessel, comprising a cooling device (1, 23) according to one of the preceding claims.

## Revendications

1. Dispositif (1, 23) de refroidissement pour un supraconducteur, notamment pour un supraconducteur à haute température d'une machine (2) synchrone, comprenant un circuit de refroidissement pour un fluide (30, 15) de refroidissement, le fluide (15) de refroidissement liquéfié dans une tête (6) froide par un condenseur (7) étant conduit au supraconducteur à refroidir, notamment dans le rotor (4) de la machine (2) synchrone, et revenant sous forme gazeuse au condenseur (7), dans lequel, pour véhiculer le fluide (30, 15) de refroidissement du condenseur (7) au supraconducteur, on se sert d'une pression produite par une partie (30), évaporée au moyen d'une source (24) de chaleur, du fluide (30, 15) de refroidissement,
**caractérisé en ce que**
- on utilise comme source (24) de chaleur une liaison, couplée par un pont (25) thermique, à un gaz (26), notamment à l'air extérieur, la température du gaz (26) étant plus haute que le point d'ébullition du fluide (30, 15) de refroidissement.

2. Dispositif de refroidissement suivant la revendication 1, **caractérisé en ce qu'**il est prévu pour le fluide (15) de refroidissement liquide un réservoir (9) qui communique par un premier tronçon (8) de conduit avec le condenseur (7) et par un deuxième tronçon (10) de conduit avec l'élément, notamment le rotor (4), portant le supraconducteur à refroidir et qui est couplé à la source (24) de chaleur.

3. Dispositif de refroidissement suivant la revendication 2, **caractérisé en ce que** le deuxième tronçon (10) de conduit est constitué sous la forme d'un tube montant.

4. Dispositif de refroidissement suivant la revendication 2 ou 3, **caractérisé en ce que** le deuxième tronçon (10) de conduit est souple au moins en partie.

5. Dispositif de refroidissement suivant l'une des revendications 2 à 4, **caractérisé en ce qu'**il est monté en amont du réservoir (9) du côté du condenseur un clapet (13, 28), notamment un clapet (13) antiretour.

6. Dispositif de refroidissement suivant la revendication 5, **caractérisé en ce que** le clapet (13) antiretour utilisant la force de gravité est monté dans la partie montante et voisine du réservoir (9) d'un siphon (12).

7. Dispositif de refroidissement suivant l'une des revendications précédentes, **caractérisé en ce que** le condenseur (7) est disposé plus bas que le supraconducteur à refroidir.

8. Machine (2) synchrone supraconductrice à utiliser notamment sur un bâtiment de navigation marin, comprenant un dispositif (1, 23) de refroidissement suivant l'une des revendications précédentes.
